Europäisches Patentamt

European Patent Office

Office européen des brevets

(19)

(11) Veröffentlichungsnummer: **0 431 253 A2**

# (12) EUROPÄISCHE PATENTANMELDUNG

(21) Anmeldenummer: 90113732.3

(22) Anmeldetag: 18.07.90

(51) Int. Cl.5: **H01J 37/34**

(30) Priorität: 11.11.89 DE 3937558

(43) Veröffentlichungstag der Anmeldung:
12.06.91 Patentblatt 91/24

(84) Benannte Vertragsstaaten:
CH DE FR GB IT LI

(71) Anmelder: **LEYBOLD AKTIENGESELLSCHAFT**
**Wilhelm-Rohn-Strasse 25**
**W-6450 Hanau am Main 1(DE)**

(72) Erfinder: **Hartig, Klaus, Dr.**
**Hanauer Strasse 17**
**W-6451 Ronneburg 2(DE)**
Erfinder: **Seiler, Reiner**
**Tilsiter Strasse 30**
**W-6450 Hanau 1(DE)**

(54) Kathodenzerstäubungsvorrichtung.

(57) Bei einer Katodenzerstäubungsvorrichtung mit einer Katode (3), die das zu zerstäubende und auf einem Substrat abzulagernde Material (11) aufweist, mit einer derart angeordneten Magneteinrichtung (2, 2', 2''), daß von der Zerstäubungsfläche (13) ausgehende und zu ihr zurückkehrende Magnetfeldlinien (6) einen Entladungsbereich (9) bilden und mit einer außerhalb der Bahnen des zerstäubten und sich von der Zerstäubungsfläche (13) zum Substrat (12) bewegenden Materials angeordneten Anode (10), wobei an der Katode (3) eine Trägerplatte (7) fest angeordnet ist, deren der Katode (3) zugewandte Seitenfläche (15) von nutenförmigen Kanälen (8) durchzogen ist, in die vom Kühlmittel durchflossene Rohre (14) eingelegt sind, deren Querschnittsprofile den Querschnittsprofilen der Kühlkanäle (8) entsprechen, so daß die Rohre (14) mit ihren Außenwänden Kontakt mit den Innenwänden der Kühlkanäle (8) bzw. der Außenfläche der Katode (3) haben, wodurch ein guter Wärmeübergang und eine hohe Betriebssicherheit erzielt wird.

FIG.1

EP 0 431 253 A2

# KATODENZERSTÄUBUNGSVORRICHTUNG

Die Erfindung betrifft eine Katodenzerstäubungsvorrichtung mit hoher Zerstäubungsrate mit einer Katode, die auf einer ihrer Oberflächen das zu zerstäubende und auf einem Substrat abzulagernde Material aufweist, mit einer derart angeordneten Magneteinrichtung, daß von der Zerstäubungsfläche ausgehende und zu ihr zurückkehrende Magnetfeldlinien einen Entladungsbereich bilden, der die Form einer in sich geschlossenen Schleife hat und mit einer außerhalb der Bahnen des zerstäubten und sich von der Zerstäubungsfläche zum Substrat bewegenden Material angeordneten Anode, wobei an der Katode eine Trägerplatte fest angeordnet ist, deren der Katode zugewandte Seitenfläche von nutenförmigen Kühlkanälen durchzogen ist.

Herkömmliche Katodenzerstäubungsvorrichtungen arbeiten entweder nach dem Prinzip der Direktkühlung des Targets oder durch Verbinden des Targets mit einer gekühlten Trägerplatte, wobei diese Verbindung entweder durch Aufschrauben oder Pratzen oder durch Aufbonden zur besseren Wärmeübertragung erfolgt. Bekannt ist auch eine Lösung, bei der der Kontakt durch eine elastische Platte geschieht, die durch den Druck des Kühlwassers gegen das Target gepreßt wird, um einen guten Wärmeübergang zu erzeugen. Bei anderen bekannten Lösungen sind die einzelnen Teile durch Löten oder Schweißen dicht miteinander verbunden, wobei der so gebildete Kühlwasserkanal targetseitig dünnwandig ausgebildet ist, um sich durch den Kühlwasserdruck an das Target anzudrücken.

Bei einer bisher bevorzugten Katodenzerstäubungsvorrichtung (DPS 24 17 288) ist die zu zerstäubende und dem zu besprühenden Substrat zugewandte Katodenoberfläche eben ausgebildet, wobei sich das Substrat nahe dem Entladungsbereich parallel zu der ebenen Zerstäubungsfläche über diese hinweg bewegen läßt. Die das Magnetfeld erzeugende Magneteinrichtung ist dazu auf der der ebenen Zerstäubungsfläche abgewandten Seite der Katode angeordnet. An der Katode dieser bekannten Zerstäubungsvorrichtung ist eine von Kühlkanälen durchzogene Kühlplatte vorgesehen, die fest an einer sehr steif ausgebildeten Befestigungsplatte anliegt, die ihrerseits mit Hilfe von Schrauben fest mit der Katode bzw. dem Target verschraubt ist. Die in der Kühlplatte vorgesehenen Kühlkanäle sind als Nuten ausgebildet, die auf der dem Target zugewandten Seite her in die Kühlplatte eingeschnitten und von der Befestigungsplatte abgedeckt sind. Nachteilig bei den genannten Vorrichtungen sind insbesondere ungünstige Wasser-Vakuum-Dichtungen oder konstruktionsbedingt ein unzureichender Kontakt mit der gekühlten Trägerplatte zum Target, sofern das Target nicht metallisch aufgebondet ist.

Der vorliegenden Erfindung liegt nun die Aufgabe zugrunde, bei Planarmagnetrons durch wirksamen Wärmekontakt der Kühlwasserführung zu der zu kühlenden Fläche (Target) eine betriebssichere und besonders rasche Wärmeabfuhr zu gewährleisten; im übrigen aber dabei auf besondere Dichtungen wie beispielsweise Rundschnurringe zu verzichten.

Erfindungsgemäß wird diese Aufgabe dadurch gelöst, daß in die Kühlkanäle vom Kühlmittel durchflossene Rohre eingelegt sind, deren Querschnittsprofile den Querschnittsprofilen der Kühlkanäle entsprechen, so daß die Rohre mit ihren Außenwänden den Kontakt mit den Innenflächen der Kühlkanäle bzw. mit der Außenfläche der Katode haben.

Vorzugsweise weist die an der Katode anliegende Trägerplatte eine im Querschnitt mäanderförmige Konfiguration auf, wobei die Kanäle jeweils von zwei sich lotrecht und einem sich parallel zur Ebene der Katode erstreckenden Schenkel oder Partien der Trägerplatte gebildet sind.

Zweckmäßigerweise sind die in die Kühlkanäle eingelegten Kühlrohre mit einer etwa parallelepipedem Querschnittskonfiguration versehen und im übrigen nahtlos ausgebildet.

Bei einer alternativen Ausführungsform weisen die Kühlrohre eine etwa parallelepipede Querschnittskonfiguration auf, wobei sie jeweils aus einer U-förmigen Profilstrebe und einem bandförmigen Zuschnitt zusammengefügt, beispielsweise gebördelt, geschweißt oder gelötet, sind.

Um eine bestimmte, kontrollierte Ausdehnung der das Kühlmittel führenden Rohre zu gestatten, sind die dünnwandigen Kühlrohre mit vorzugsweise sich in deren Längsrichtung erstreckenden Sicken oder Faltungen versehen.

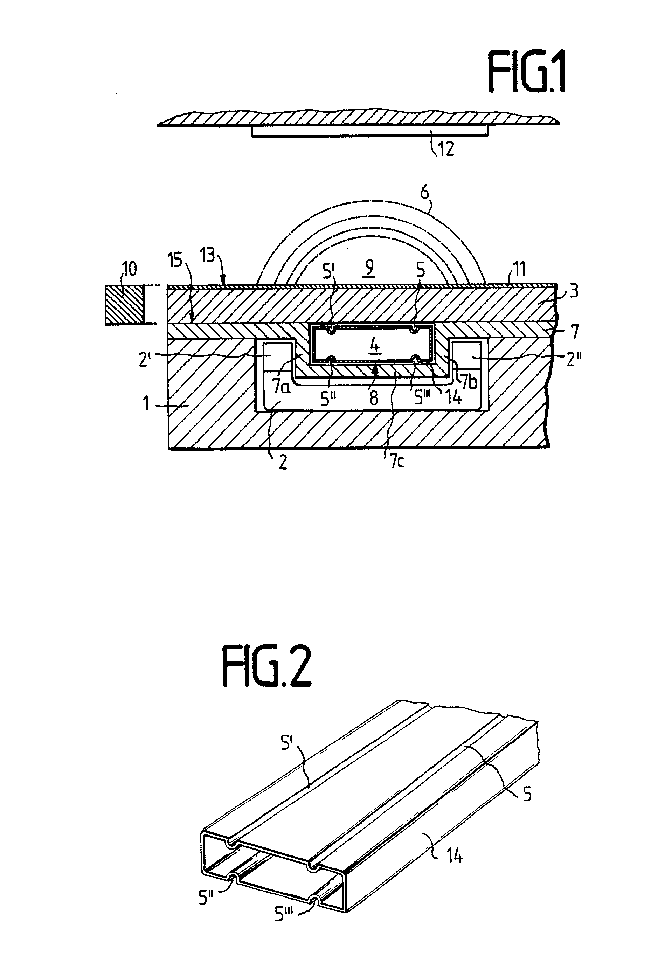

Die Erfindung läßt die verschiedensten Ausführungsmoglichkeiten zu; eine davon ist in der anhängenden Zeichnung, die in Figur 1 einen Teilschnitt durch eine planare Magnetron-Katode und in Figur 2 das Teilstück eines Kühlrohres zeigt, schematisch näher dargestellt.

Die Katodenzerstäubungsvorrichtung nach der Zeichnung weist eine ebene Katode 3 auf, die auf über Katodenoberfläche 13 das zu zerstäubende Material 11 (das Target) aufweist. Eine Magneteinrichtung 2, 2', 2'' erzeugt ein Magnetfeld, dessen Feldlinien 6 von der Katodenoberfläche 13 ausgehen, dann bogenförmig über einen Entladungsbereich 9 verlaufen und anschließend zur Katodenoberfläche 13 zurückkehren. Eine rund um die Katode 3 mit Abstand herumgelegte, jedoch in der Zeichnung nicht näher dargestellte Anode 10 erzeugt zusammen mit der Katode 3 ein elektrisches Beschleunigungsfeld für elektrisch geladene Teilchen.

Das auch als Target bezeichnete Teil 3, 11 ist mit einer Trägerplatte 7 fest verbunden, z.B. verschraubt, in die Nuten oder Kanäle 8 eingeschnitten, beispielsweise eingefräst sind und zwar derart, daß diese Kanäle 8 sich jeweils im Bereich von rippenartigen Partien der Trägerplatte 7 befinden, so daß dabei jeweils zwei sich vertikal zur Ebene der Katode 3 und ein sich parallel zu dieser erstreckende Abschnitte 7a, 7b bzw. 7e ergeben. Diese rippenartigen Partien der Trägerplatte 7 sind jeweils von einem U-förmigen Magnetjoch 2 übergriffen, dessen beide Schenkel 2', 2" sich jeweils im Bereich der vertikalen Abschnitte 7a, 7b der Trägerplatte 7 befinden. Das Magnetjoch 2, 2', 2" ist seinerseits von einem Katodengrundkörper 1 gehalten, der gleichzeitig auch mit der Trägerplatte 7 bzw. dem Target 3, 11 fest verbunden ist. In die Nuten oder Kanäle 8 sind die das Kühlmittel 4 führenden,im Querschnitt etwa rechteckigen, Kühlrohre 14 eingelegt, die im übrigen so dimensioniert sind, daß jeweils drei ihrer Außenflächen nahezu spaltlos an den Innenflächen der Kanäle 8 und jeweils eine ihrer Außenflächen an der Katoden-Innenfläche (15) anliegen.

Da das Kühlmittel 4 während des Beschichtungsvorganges mit einem vergleichsweise hohen Druck durch die Rohre 14 gedrückt wird, sind diese so ausgebildet bzw. bemessen, daß sie sich geringförmig aufweiten können, so daß ihre Außenflächen dann satt an den Innenwänden des entsprechenden Kühlkanals 8 bzw. an der Katode 3 anliegen. Ein gleichmäßiges bzw. kontrolliertes Ausdehnen der Kühlrohre 14 wird konstruktiv dadurch begünstigt, daß die Rohre 14 mit vier sich in ihrer Längsrichtung erstreckenden Faltungen 5, 5', 5", 5"' ausgestattet sind, die sich bei Druckerhöhung entsprechend abflachen.

Die Kühlrohre 14 sind aus einem Werkstoff gefertigt, der insbesondere gegenüber dem Kühlmittel besonders korrosionsfest ist. Zweckmäßigerweise ist der Werkstoff für die Rohre 14 mit Vorteil von hoher Zähigkeit bzw. Dehnbarkeit, so daß ein Platzen der Rohre 14 während des Betriebes praktisch ausgeschlossen ist, was wesentlich zu einer allgemein höheren Betriebssicherheit der Katodenzerstäubungsvorrichtung beiträgt.

## Ansprüche

1. Katodenzerstäubungsvorrichtung mit hoher Zerstaubungsrate mit einer Katode (3), die auf einer ihrer Oberflächen (13) das zu zerstäubende und auf einem Substrat (12) abzulagernde Material (11) aufweist, mit einer derart angeordneten Mangeteinrichtung (2, 2', 2"), daß von der Zerstaubungsfläche (13) ausgehende und zu ihr zurückkehrende Magnetfeldlinien (6) einen Entladungsbereich (9) bilden, der die Form einer in sich geschlossenen Schleife hat und mit einer außerhalb der Bahnen des zerstäubten und sich von der Zerstäubungsfläche (13) zum Substrat (12) bewegenden Materials angeordneten Anode, wobei an der Katode (3) eine Trägerplatte (7) fest angeordnet ist, deren der Katode (3) zugewandte Seitenf läche (15) von nutenförmigen Kanälen (8) durchzogen ist, **dadurch gekennzeichnet**, daß in die Kanäle (8) vom Kühlmittel (4) durchflossene Rohre (14) eingelegt sind, deren Querschnittsprofile den Querschnittsprofilen der Kanäle (8) entspricht, so daß die Rohre (14) mit ihren Außenwänden Kontakt mit den Innenwänden der Kanäle (8) bzw. der Außenfläche (15) der Katode (3) haben.

2. Katodenzerstäubungsvorrichtung nach Anspruch 1, **dadurch gekennzeichnet**, daß die an der Katode (3) anliegende Trägerplatte (7) eine im Querschnitt mäanderförmige Konfiguration aufweist, wobei die Kanäle (8) jeweils von zwei sich lotrecht und einem sich parallel zur Ebene der Katode (3) erstreckenden Schenkel oder Partien (7a, 7b bzw. 7c) der Trägerplatte (7) gebildet sind.

3. Katodenzerstäubungsvorrichtung nach den Ansprüchen 1 und 2, **dadurch gekennzeichnet**, daß die in die Kanäle (8) eingelegten Kühlrohre (14) eine etwa parallelepipede Querschnittskonfiguration aufweisen und nahtlos ausgebildet sind.

4. Katodenzerstäubungsvorrichtung nach den Ansprüchen 1 und 2, **dadurch gekennzeichnet**, daß die Kühlrohre eine etwa parallelepipede Querschnittskonfiguration aufweisen und jeweils aus einer im Querschnitt U-förmigen Profilstrebe und einem bandförmigen Zuschnitt zusammengefügt, beispielsweise -gebördelt, -geschweißt oder -gelötet sind.

5. Katodenzerstäubungsvorrichtung nach einem oder mehreren der vorhergehenden Ansprüche, **dadurch gekennzeichnet**, daß die dünnwandigen Kühlrohre (14) mit vorzugsweise sich in deren Längsrichtung erstreckende Sicken oder Faltungen (5, 5', 5", 5"') versehen sind.

## Auflistung der Einzelteile

1 Katodengrundkörper
2, 2', 2" Mangeteinrichtung, Magnetjoch
3 Katode, Target
4 Kühlmittel
5, 5', 5", 5"' Faltung
6 Feldlinien
7 Trägerplatte
8 Nut, Kanal
9 Entladungsbereich
10 Anode
11 Targetwerkstoff, zerstäubbares Material

12 Substrat
13 Zerstäubungsfläche
14 Kühlrohr
15 Seitenfläche

# FIG.1

# FIG.2